# EUROPÄISCHE PATENTSCHRIFT

(11) **EP 3 180 456 B1**
(45) Veröffentlichungstag und Bekanntmachung des Hinweises auf die Patenterteilung: **01.05.2019**
(21) Anmeldenummer: 15785048.8
(22) Anmeldetag: 05.08.2015
(51) Int. Cl.: C23C 16/52, H01J 37/32, C23C 14/35, C23C 14/56, H01J 37/34

(54) **VERFAHREN UND VORRICHTUNG ZUR ENERGIEEINSPARUNG UND GLEICHZEITIGEN ERHÖHUNG DER DURCHLAUFGESCHWINDIGKEIT BEI VAKUUM-BESCHICHTUNGSANLAGEN**
METHOD AND APPARATUS FOR SAVING ENERGY WHILE INCREASING THE CONVEYING SPEED IN VACUUM COATING PLANTS
PROCÉDÉ ET DISPOSITIF POUR ÉCONOMISER DE L'ÉNERGIE TOUT EN AUGMENTANT LA VITESSE DE PASSAGE DANS DES INSTALLATIONS DE REVÊTEMENT SOUS VIDE

(30) Priorität: 11.08.2014 DE 102014011877
(43) Veröffentlichungstag der Anmeldung: 21.06.2017
(73) Patentinhaber: Grenzebach Maschinenbau GmbH, 86663 Asbach-Baeumenheim (DE)
(72) Erfinder: KLEIDEITER, Gerd, 48683 Ahaus (DE); KRISCH, Thomas, 63589 Linsengericht / Lützelhausen (DE); FIUKOWSKI, Jörg, 04860 Torgau (DE); GAWER, Olaf, 01328 Dresden (DE)
(74) Vertreter: Kindermann, Peter
(86) Internationale Anmeldenummer: PCT/DE2015/000397
(87) Internationale Veröffentlichungsnummer: WO 2016/023533

(56) Entgegenhaltungen:
- JP-A- 2002 081 857
- US-A1- 2005 199 185
- US-A1- 2008 283 393

## Beschreibung

Die Erfindung betrifft ein Verfahren und eine Vorrichtung zur Beschichtung mittels Sputtern und insbesondere ein Verfahren und eine Vorrichtung zur Energieeinsparung und gleichzeitigen Erhöhung der Durchlaufgeschwindigkeit bei Vakuum - Beschichtungsanlagen.

Die magnetfeldunterstützte Kathodenzerstäubung (Magnetron Sputtering) hat Eingang gefunden in viele Bereiche der modernen Oberflächentechnik.
Ausgehend von Anwendungen in der Mikroelektronik ist die magnetfeldunterstützte Kathodenzerstäubung heute als industrielles Beschichtungsverfahren für Architekturglas, Flachbildschirme, Brillengläser, Bandmaterialien, Werkzeug, dekorative Gegenstände und funktionelle Bauteile etabliert. Dabei werden funktionelle Bauteile oft mit Korrosionsschutz oder Hartstoffschichten aus Nitriden wie TIN, TANN, VN, ZrN oder Karbonitriden wie TICN in Ein - oder Mehrlagentechnik versehen. Zunehmend finden auch superharte Schichten auf Basis von Nano-Mehrlagenschichten mit Härtewerten bis zu 50 GPa Anwendung. In der Automobilindustrie sind reibungs- und verschleißmindernde Metall-Kohlestoff-Schichten bestens bewährt.
Die größten Vakuumbeschichtungsanlagen, und damit oftmals auch die Anlagen mit dem höchsten Energiebedarf, sind die typischen horizontalen In-Line-Anlagen für die Architekturglasbeschichtung.

Aus dem Stand der Technik wird auf die folgenden Druckschriften verwiesen

Aus der DE 10 2012 110 334 B3 ist ein Planarmagnetron bekannt, dem die Zielsetzung zugrunde liegt, ein Planarmagnetron zu schaffen, das die Nachteile des Standes der Technik nicht aufweist und mit dem insbesondere ein gleichmäßigeres Magnetfeld erzielt wird. Die aufgezeigten Nachteile beziehen sich hierbei auf den Stand der Technik wie er in der US 5 407 551 A offenbart wird.
Der Patentanspruch 1 bezieht sich hier auf ein Planarmagnetron für Vakuumbeschichtungsanlagen zur Beschichtung von Glasplatten oder anderen flächigen Substraten, mit einer Magnetanordnung, bestehend aus einer magnetisierbaren Rückschlussplatte, mit daran angeformten längs verlaufenden Polschuhen und zugehörigen Permanentmagneten, sowie mit mindestens einem Target an der Magnetanordnung, sowie Kühlkanälen zum Hindurchleiten einer Kühlflüssigkeit durch das Planarmagnetron.
Gekennzeichnet ist dieses Planarmagnetron dadurch, dass die Rückschlussplatte über deren gesamten Länge einen gleichbleibenden Querschnitt aufweist und mit sich längs in der Rückschlussplatte erstreckenden Aufnahmen zur Befestigung von Anbauteilen, wie mindestens einem Kühlkanal mit Vor- und Rücklauf und Pratzleisten zur Befestigung von mindestens einem Target versehen ist.

Weiter beschreibt die DE 101 22 310 A1 eine längserstreckte Vakuumbeschichtungsanlage der die Zielsetzung zugrunde liegt, die Zugänglichkeit zur Glastransportebene in längserstreckten Vakuumbeschichtungsanlagen zu verbessern, um die Wartung einfacher und kostengünstiger zu gestalten.

Diese Zielsetzung wird bei einer längserstreckten Vakuumbeschichtungsanlage zur Beschichtung von in einer Transportrichtung bewegten flachen Substraten mit mindestens einem Beschichtungsmodul, welches mindestens zwei Beschichtungssektionen aufweist, die in Transportrichtung hintereinander liegen, und einem Transportsystem, über dem sich ein Transportraum für die Substrate befindet, erreicht. Hierbei reicht der Transportraum über Substratführungsschlitze in den Wandungen der Beschichtungssektionen durch die Beschichtungssektionen hindurch, wobei die Beschichtungssektionen je einen eine Deckelöffnung verschließenden Deckel aufweisen, an dem mindestens ein Magnetron derart befestigt ist, dass es über dem Transportraum angeordnet ist und wobei die Beschichtungssektionen mittels Vakuumpumpen über Vakuumführungskanäle evakuierbar sind.
Gekennzeichnet ist diese Vakuumbeschichtungsanlage dadurch, dass die Vakuumbeschichtungsanlage oberhalb des Transportraums in ein für alle Beschichtungssektionen eines Beschichtungsmoduls gemeinsames Kammerunterteil und ein für alle Beschichtungssektionen eines Beschichtungsmoduls gemeinsames Kammeroberteil geteilt ist, beide Kammerteile in Arbeitsstellung miteinander vakuumdicht verschließbar und in Wartungsstellung relativ zueinander bewegbar sind.

Aus der Druckschrift US 2008/283393 A1 sind eine Vorrichtung und ein Verfahren zur Beschichtung mittels Sputtern bekannt, bestehend aus einer Abfolge von Sputter-Segmenten und Gas-Trennsegmenten mit einer durchlaufenden Substrat-Ebene, wobei die Sputter-Segmente aus einer Kessel-Wanne mit einer innenliegenden Transporteinrichtung zum Transport von Substraten und mindestens einem Kesseldeckel der mit der Kessel-Wanne verbunden ist, bestehen, wobei sich ein Kathoden-Lagerblock mit Targets und Gas-Einlasskanälen in unmittelbarer Substratnähe mit Spritzblechen im Kessel-Deckel befinden.

Die Druckschrift JP 2002 081857 A offenbart eine Vorrichtung und ein Verfahren zur Beschichtung mittels Sputtern, wobei mittels Vakuumpumpen die Prozessgase abgesaugt und in einem Tank zwischengelagert werden. Nach der Lagerung werden diese wieder in die Prozesskammer zurückgeleitet.

Ferner sind aus der Druckschrift US 2005/199185 A1 eine weitere herkömmliche Vorrichtung und ein Verfahren zur Vakuumbeschichtung bekannt, bestehend einer Abfolge von Sputter- und Gas-Trennsegmenten mit einer durchlaufenden Substratebene. Die Sputter-Segmente weisen einen Kessel mit einer innenliegenden Transporteinrichtung zum Transport von Substraten auf und die Gas-Trennsegmente weisen eine über die gesamte Länge verlaufende Tunneldecke auf.

Der Erfindung liegt die Aufgabe zugrunde, ein Verfahren und eine Vorrichtung zur Beschichtung mittels Sputtern zu schaffen, wobei die Produktivität und die Standzeit verbessert ist.

Erfindungsgemäß wird diese Aufgabe hinsichtlich der Vorrichtung durch die Merkmale des neuen Patentanspruchs 1 und hinsichtlich des Verfahrens durch die Maßnahmen des neuen Patentanspruchs 5 gelöst.

In den Unteransprüchen sind weitere vorteilhafte Ausgestaltungen der Erfindung gekennzeichnet.

Die Erfindung wird im Folgenden an Hand von Ausführungsbeispielen näher beschrieben.

Es zeigen im Einzelnen:
Fig.1: den prinzipiellen Aufbau einer Vakuum-Beschichtungsanlage,
Fig.2: eine Gegenüberstellung zweier Anordnungen von Kesseln,
Fiq.3: eine Detail - Ansicht typischer Segmente aus der Fig.1,
Fiq.4: den prinzipiellen Aufbau eines Vakuum-Speichers 25,
Fig.5: einen Luftspeicher 25 und ein Sputter-Segment,
Fig.6: einen Querschnitt durch einen Target-Bereich,
Fig.7: die Darstellung einer Mehrfach-Kathode, und
Fig.8: die Abdichtung einzelner Kessel-Wannen 12.

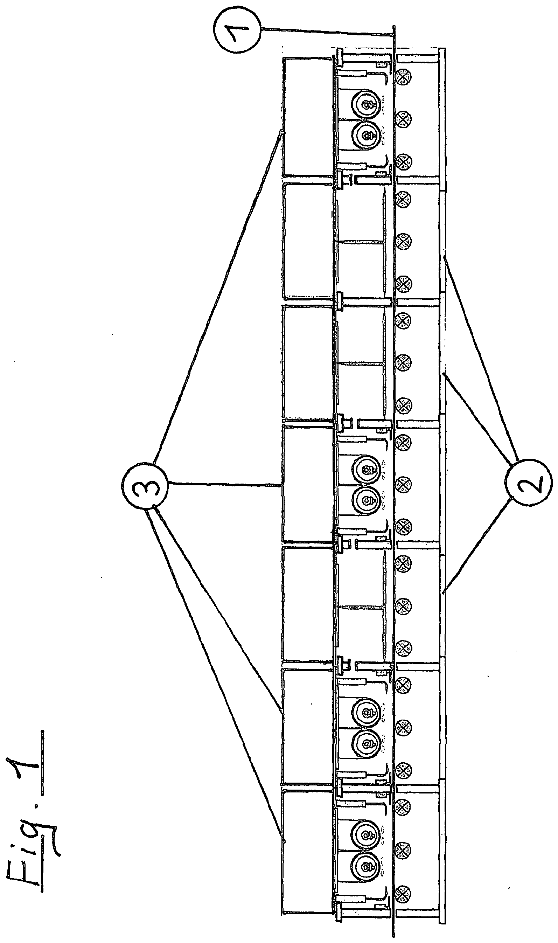

Die Fig.1 zeigt den prinzipiellen Aufbau einer Vakuum-Beschichtungsanlage. Eine Vakuum-Beschichtungsanlage besteht im Wesentlichen aus einer Abfolge von Sputter-Segmenten 3 und Gas-Trennsegmenten 2. Die zu beschichtenden Substrate werden hierbei auf der dargestellten Substrat-Ebene 1 von einem Segment zu dem nächsten Segment befördert.

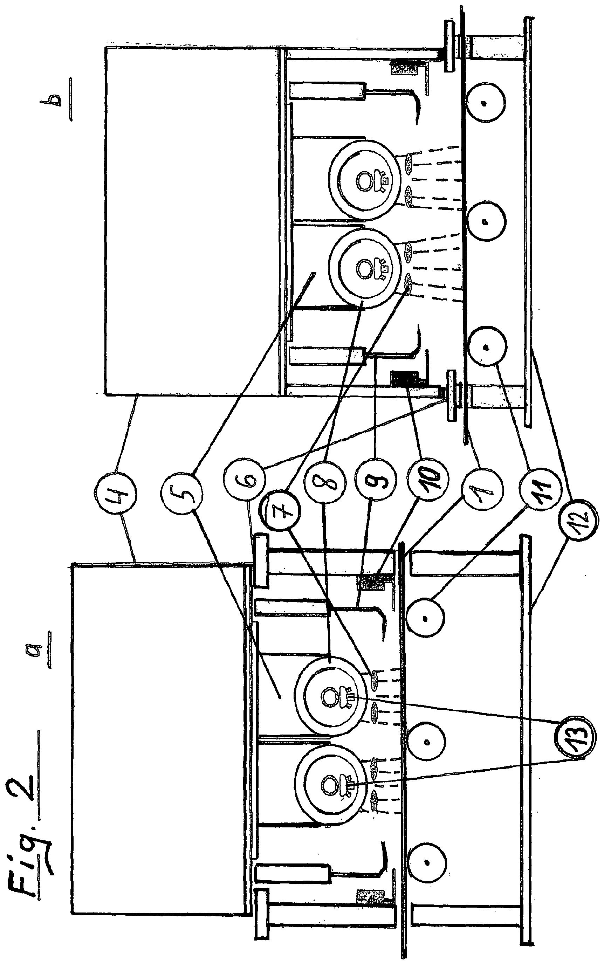

Die Fig.2 zeigt eine Gegenüberstellung zweier Anordnungen von Kesseln.
In der Fig. 2a) ist hierbei die konventionelle Bauform eines Sputter-Kessels im Querschnitt dargestellt, während in der Fig. 2b) die erfindungsgemäße Bauform im Querschnitt gezeigt ist.
Augenfällig ist hierbei der Unterschied beider Bauformen in Bezug zu der Ebene des jeweiligen Deckel-Flanschs 6. Während bei der konventionellen Bauform auf der linken Seite der Deckel-Flansch 6 relativ hoch angesetzt ist, ist dies bei der Bauform auf der rechten Seite nicht der Fall. Der Grund hierfür ist darin zu sehen, dass bei der konventionellen Bauform die auf der linken und auf der rechten Seite gezeigten Spritzbleche 9 der Sputter - Bereichsabschirmung bei einem Wechsel des Kessel - Deckels 4 mit den beiden Kathoden - Lagerblöcken 5 von den beiden Lager - Flanschen 6 abgenommen werden, jedoch die , links und rechts gezeigten, Gas - Einlasskanäle 10 im Grundkörper des Beschichtungs - Kessels verbleiben. Da bei jedem Wechsel des Kessel - Deckels 4 umfangreiche und zeitraubende Reinigungsarbeiten anstehen, ist bei der konventionellen Bauweise nach der Fig. 2a) ein hoher Kostenfaktor einzuplanen. Bei der erfindungsgemäßen Bauform nach der Fig.2b) kann der Wechsel eines Kessel - Deckels 4 jedoch viel schneller erfolgen, da die Gas - Einlasskanäle als integrierter Bestandteil eines Kessel - Deckels 4 während eines vorhergehenden oder eines nachfolgenden Sputter - Prozesses mitsamt den anderen Bestandteilen eines Kessel - Deckels sorgfältig, in Ruhe und kostengünstig gereinigt werden können.Weiter sind in der Fig.2 die jeweilige Kessel - Wanne 12 und die Transporteinrichtung 11 zum Transport der Substrate 1 bezeichnet. Ferner sind die Target - Einheiten 8 mit den zugehörigen Plasma - Bereichen 7 und die jeweilige Magnetbar 13 in der konventionellen Bauform eingezeichnet.

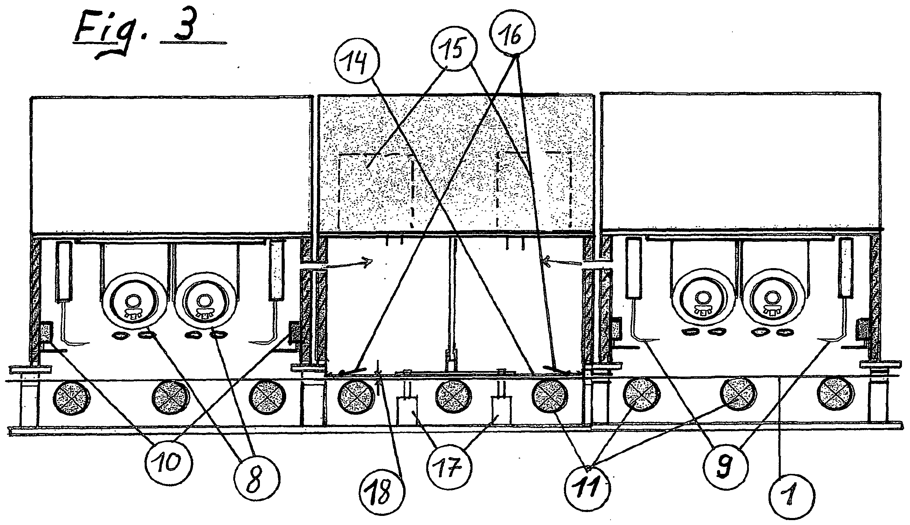

Die Fig.3 zeigt eine Detail - Ansicht typischer Segmente aus der Fig.1.
Die hier gezeigten Segmente bestehen links und rechts aus jeweils einem Sputter - Segment, wobei diese beiden Sputter - Segmente durch ein Gas - Trennsegment getrennt sind. Auf der allen Segmenten gemeinsamen Substrat - Ebene 1 werden diese Segmente von dem jeweils zu beschichtenden Substrat durchlaufen. Da in jedem Sputter - Segment im Allgemeinen ein anderer Beschichtungsprozess mit einem anderen Target und einem anderen Gasgemisch stattfindet, ist in dem gezeigten Beispiel zwischen den beiden Sputter - Segmenten ein Gas - Trennsegment zwischengeschaltet um zu verhindern, dass die Gasmischung aus dem einen Sputter - Segment mit dem Gasgemisch aus dem anderen Sputter - Segment in Berührung kommt.
Im linken Sputter - Segment der Fig.3 sind die beiden Targets 8 und die beiden Gas - Einlasskanäle 10 bezeichnet. Im rechten Sputter - Segment sind die beiden Spitzbleche der Sputter - Bereichsabschirmung 9 und zwei Laufrollen der Transporteinrichtung 11 für den Transport des betreffenden Substrats besonders gekennzeichnet. Im mittleren Gas - Trennsegment sind im Kessel - Deckel zwei, mittels eines Trennblechs dem jeweiligen angrenzenden Sputter - Segment durch Zuströmkanäle zugeordneten, Vakuumpumpen 15 gezeigt. Als Besonderheit sind hier im Bereich der Substrat - Ebene 1 zwei Hub - und Absenkelemente 17 für einen so genannten Tunneldeckel 14 dargestellt. Hierbei handelt es sich um eine Anordnung die es ermöglicht den Tunneldeckel 14, der das durchlaufende Substrat auf der gesamten Länge und Breite des Substrats vom übrigen Raum des Gas - Trennsegments abzuschirmen und entsprechend der unterschiedlichen Dicke des jeweils durchlaufenden Substrats soweit anzuheben oder abzusenken, dass der so genannte Freiraum - Spalt minimal wird. Bei dem Freiraum - Spalt 18 handelt es sich somit um den Abstand zwischen dem Substrat und dem das Substrat abdeckenden Tunneldeckel 14 der für einen ungestörten Durchlauf des jeweiligen Substrats absolut notwendig ist. Die Dicke des jeweils durchlaufenden Substrats wird hierbei von einem, nicht näher bezeichneten, Sensor rechtzeitig ermittelt und das somit gewonnene Steuersignal wird zur Steuerung der Hub - und Absenkelemente 17 verwendet. Im Bereich der Trennwände des gezeigten Gas - Trennsegments befindet sich auf der Höhe der Substrat - Ebene jeweils eine Tunneldeckel - Klappe in der Funktion eines Rückschlagventils um das Einströmen von Mischgas aus dem jeweils benachbarten Segment zu verhindern.

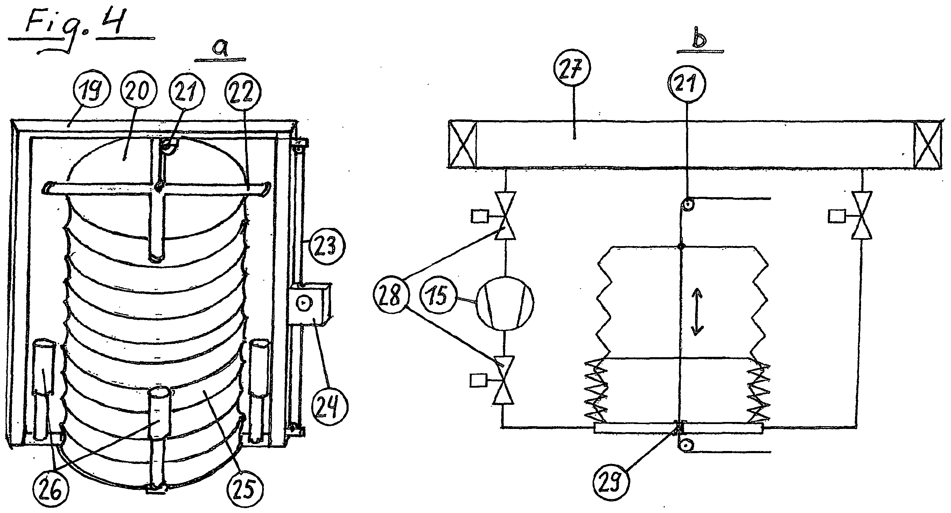

Die Fig.4 zeigt den prinzipiellen Aufbau eines Vakuum - Speichers 25.
In der Fig. 4a) ist hier beispielhaft eine technische Ausführung des in der Fig.4b) gezeigten prinzipiellen Funktionsprinzips gezeigt.
Die jeweilige Vakuum - Kammer 27 wird mittels einer oder mehrerer Vakuumpumpen 15 evakuiert. Die dabei durch die Vakuumpumpe 15 geförderte Luft wird in einem volumenveränderlichen Luftspeicher 25 aufgefangen. In der Regel wird der volumenveränderliche Luftspeicher 25 so ausgelegt, dass dieser durch den erzeugten Druck der Vakuumpumpe 15 aufgeblasen wird.
Beim anschließenden Belüften der Vakuum - Kammer 27 wird die im volumenveränderlichen Luftspeicher 25 gespeicherte Luft durch den Unterdruck wieder in die Vakuum - Kammer 27 befördert. Der Vorteil der in der Fig. 4b) dargestellten Lösung liegt darin, dass schon einmal konditionierte Luft eines bestimmten Trocknungsgrads wieder verwendet wird und damit auf eine Ausrüstung zum Trockenlüften neuer Luft verzichtet werden kann. Die dargestellten Absperrventile 28 dienen der Steuerung der Luftströme.
Der Einströmvorgang der im volumenveränderlichen Luftspeicher 25 gespeicherten Luft bei dem Belüften der Vakuum - Kammer 27 kann durch eine, auf den Luftspeicher 25 wirkende Kraft, die die Verkleinerung seines Volumens unterstützt, gefördert werden. Dies wird beispielhaft mittels eines, im oberen Bereich des Luftspeichers 25 am Speicherdeckel 20 angebrachtes Deckelkreuz 22 erreicht, wobei dieses Deckelkreuz 22 durch ein Zugseil 23, das durch ein Zugseil - Dichtelement 29 im Boden des Luftspeichers 25 und eine weitere, nicht näher bezeichnete Umlenkrolle verläuft, nach unten gezogen wird und zu einem Zugseil Antriebselement 24 zurück läuft.
Der Luftspeicher 25 kann hierbei beispielhaft mittels einer, an einem Speicher - Portal 19 befestigten Umlenkrolle 21 in seiner Lage fixiert sein.
Zur zusätzlichen Kraftunterstützung bei dem Vorgang einer wiederum später folgenden Evakuierung der Vakuum - Kammer 27 können im unteren Bereich des Luftspeichers 25 vier Federelemente 26 vorgesehen sein, die in ihrer Lage mit dem Deckelkreuz 22 in der Weise zusammen arbeiten, dass sie mittels des Zugseils 23 zusammen gedrückt werden und somit als Energiespeicher wirken. Die auf diese Weise in den Federelementen 26 gespeicherte Energie kann somit die Arbeit der Vakuumpumpe 15im folgen Evakuierungsprozess unterstützen.

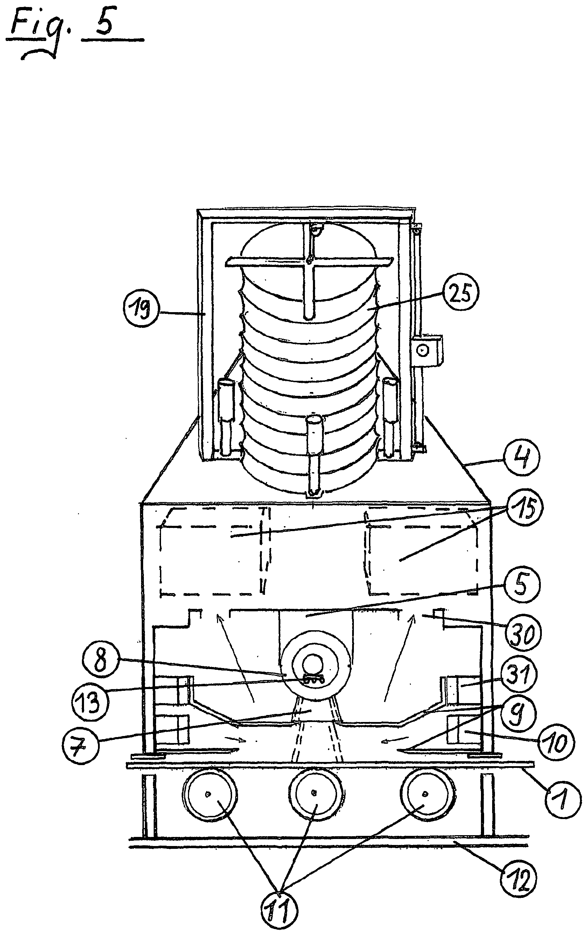

Die Fig.5 zeigt einen Luftspeicher 25 und ein Sputter - Segment.
Hier wird ein Sputter - Segment dargestellt auf dem ein volumenveränderlicher Luftspeicher 25 integriert ist. Als neue Bezugszeichen sind hier auf der linken und der rechten Seite des Kessels jeweils eine Absaugöffnung 30 dargestellt die zu jeweils einer Vakuumpumpe 15 führen. Die übrigen Bezugszeichen wurden schon beschrieben.
Als besondere Ausgestaltung ist ferner auf der rechten Seite des Kessels ein Verschiebe - Einrichtung 31 für die genaue Justierung der Lage eines speziellen Spritzblechs 9 zu erkennen. Diese Einrichtung 31 befindet sich auch auf der linken Seite des Kessels.
Ein solcher Luftspeicher kann bevorzugt auch einer Eintritts - Kammer oder einer Transfer - Kammer angeordnet sein.

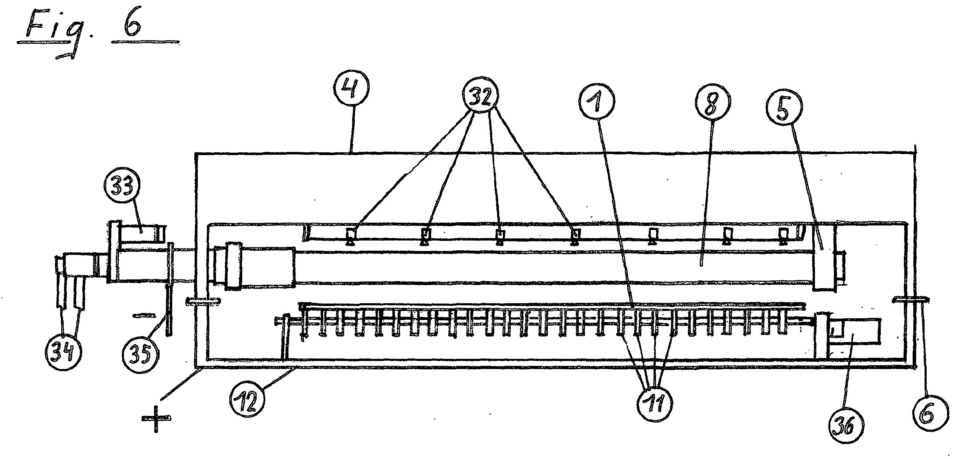

Die Fig. 6 zeigt einen Querschnitt durch einen Target - Bereich.
In dieser Fig. 6 ist die flache Bauart des erfindungsgemäßen Kessels im Querschnitt besonders gut zu erkennen. Neben dem Kessel - Deckel 4, der Kessel - Wanne 12 sind auch ein Deckel - Flansch 6 und die Substrat - Ebene 1 bezeichnet. Zur Beförderung der Substrate dienen die im Schnitt dargestellten Rollen der Transportvorrichtung 11 mit ihrem Transportrollen - Antrieb 36.. Die Lagerung des zylinderförmigen Targets 8 erfolgt auf der rechten Seite durch den Kathoden - Lagerblock 5 und auf der linken Seite durch eine entsprechende Lagerung im Kessel. Der Target - Antrieb 33 wird gekühlt mittels eines Kühlwasser - Kreislaufs 34. In diesem Bereich befindet sich auch die elektrische Energieversorgung 35. Hier liegt eine Gleichspannung bis zu 100 Volt an, wobei der positive Pol am Gehäuse anliegt und der negative Pol am Target 8.
Zur Überwachung des Ergebnisses des Beschichtungsprozesses dienen die Detektions - Elemente 32. Hierbei können die Detektionselemente 32 auf ihrer Lage - Einrichtung verschoben werden und hinsichtlich ihres Erfassungsbereichs lageunabhängig gedreht werden. Die entsprechenden Vorrichtungen sind aus Gründen der aufwendigen Darstellung nicht gezeichnet.

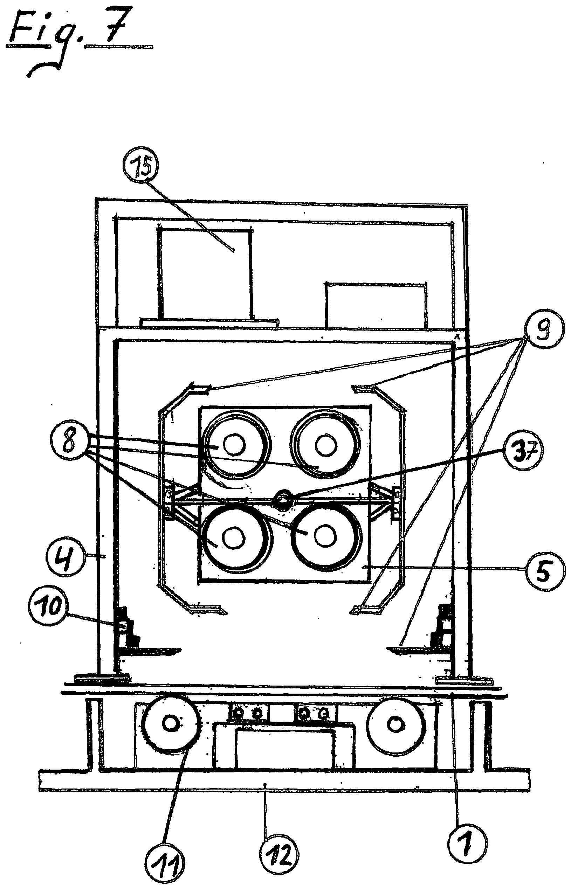

Die Fig.7 zeigt die Darstellung einer Mehrfach - Kathode.
Hier ist eine Kessel - Wanne 12 mit einem Substrat 1, der Transporteinrichtung 11 und einer Vakuumpumpe 15, im Querschnitt dargestellt, die im Kessel - Deckel 4 eine spezielle Ausgestaltung eines Kathoden - Lagerblocks 5 aufweist. In der Mitte des hier gezeigten Kessels befindet sich ein Lagerblock 5 der eine Mehrfach - Kathode in der Form zweier normaler übereinander liegender Doppel - Targets aufweist, wobei diese mitsamt ihren Spritzblechen 9 um eine gemeinsame Drehachse 37 drehbar gelagert sind. Dies ermöglicht einen Wechsel zweier Targets nach erfolgter Abnutzung ohne den jeweiligen Kessel öffnen zu müssen. Es wird aber auch möglich, ohne den Gesichtspunkt einer eventuellen Abnutzung, verschiedenartige Targets während eines Beschichtungsprozesses zum Einsatz zu bringen. Die Gas - Einlasskanäle 10 bleiben hiervon unberührt.
Diese Anordnung ermöglicht 4 Einrastpositionen und damit vier verschiedene Beschichtungskonfigurationen, jeweils um 90° zueinander versetzt, ohne das Spritzblech und Beschichtungs-Kathode miteinander gekoppelt wären.

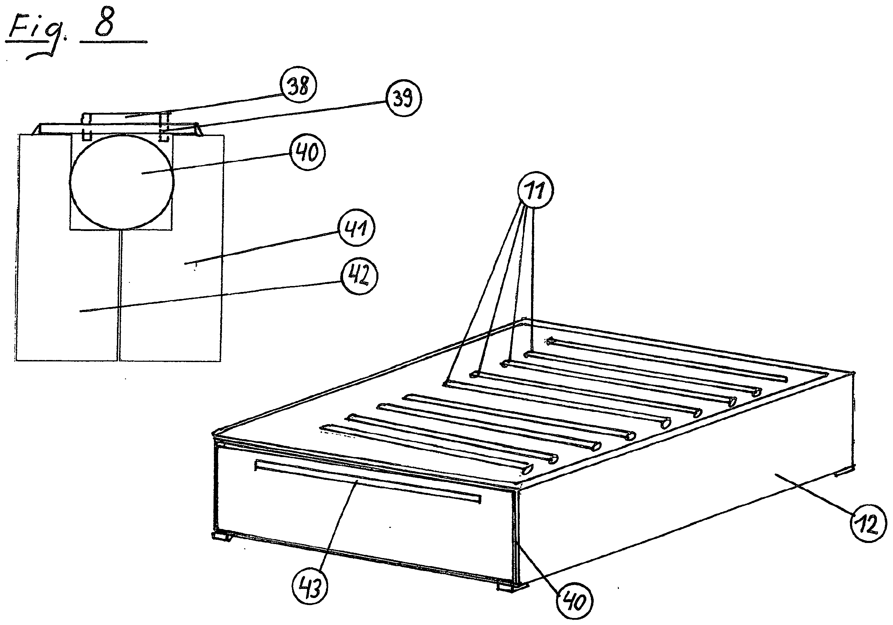

Die Fig.8 zeigt die Abdichtung einzelner Kessel - Wannen 12.
Zur Aufrechterhaltung der Vakuum - Bedingungen während des Beschichtungsprozesses ist es notwendig zwischen den einzelnen Sputter - Segmenten 3 und / oder den Gas - Trennsegmenten 2 eine sichere Abdichtung zu schaffen die eine ununterbrochene Verbindung der einzelnen Tor - Öffnungen 43 der Substratebene beim Durchgang der zu beschichtenden Segment gewährleistet. Beispielhaft ist hier in der Fig.8 die Verbindung zwischen zwei Kammern 41 und 42 in der Form zweier Kessel gezeigt, wobei die räumlich dargestellte Kessel - Wanne 12 mit den einzelnen Laufachsen ihrer Transporteinrichtung 11 einen außen, am gesamten Umfang umlaufenden, die Tor - Öffnung 43 abdichtenden, Dichtring 40 aufweist.
In der ebenfalls gezeigten Detailzeichnung der Fig.8 ist der Eckbereich zweier nebeneinander liegender Kammern 41 und 42 zu erkennen, die mittels des Dichtrings 40 von dem, unter Normal - Luftdruck beherrschten, Außenbereich abgedichtet sind.
Zusätzlich ist hier ein äußeres Dichtband 39 vorgesehen, wobei der Raum zwischen dem Dichtring 40 und dem Dichtband 39, hier stilisiert dargestellt von einem Vakuum - Sensor 38 überwacht wird.

### Bezugszeichenliste

- 1: Substrat, Substrat - Ebene
- 2: Gas - Trennsegmente
- 3: Sputter - Segmente
- 4: Kessel - Deckel
- 5: Kathoden - Lagerblock
- 6: Deckel - Flansch
- 7: Plasma - Bereich
- 8: Target
- 9: Spritzblech, Sputter - Bereichsabschirmung
- 10: Gas - Einlasskanäle
- 11: Transporteinrichtung
- 12: Kessel - Wanne
- 13: Magnetbar
- 14: Tunneldeckel
- 15: Vakuumpumpe
- 16: Tunneldeckel - Klappe
- 17: Hub - und Absenkelemente für einen Tunneldeckel
- 18: Freiraum - Spalt
- 19: Speicher - Portal
- 20: Speicher - Deckel
- 21: Umlenkrolle
- 22: Deckelkreuz, Anschlag für Federelemente 26
- 23: Zugseil
- 24: Zugseil - Antriebselement
- 25: volumenveränderlicher Luftspeicher
- 26: Federelement, Kraftverstärker bei Vakuumbetrieb
- 27: Vakuum - Kammer (Kessel)
- 28: Absperrventil
- 29: Zugseil - Dichtelement
- 30: Absaugöffnung
- 31: Verschiebe - Einrichtung für Spritzblech 9
- 32: Detektions - Element zur Kontrolle der Beschichtung
- 33: Traget - Antrieb
- 34: Kühlwasser - Kreislauf
- 35: Anschluß der elektrischen Energieversorgung
- 36: Transportrollen - Antrieb

## Patentansprüche

1. Vorrichtung zur Beschichtung mittels Sputtern,
die aus einer Abfolge von Sputter-Segmenten (3) und Gas-Trennsegmenten (2) mit einer durchlaufenden Substrat-Ebene (1) besteht, wobei
die Sputter-Segmente (3) jeweils aus einer Kessel-Wanne (12) mit einer innenliegenden Transporteinrichtung (11) zum Transport von Substraten (1) und mindestens einem Kesseldeckel (4) der mittels eines Kessel-Flanschs (6) mit der Kessel-Wanne (4) verbunden ist, bestehen, wobei der Kessel-Flansch (6) in unmittelbarer Nähe über der Substrat-Ebene (1) angesetzt ist und wobei sich ein Kathoden-Lagerblock (5) mit Targets (8) und Gas-Einlasskanälen (10) in unmittelbarer Substratnähe mit Spritzblechen (9) im Kessel-Deckel (4) befinden,
**dadurch gekennzeichnet, dass**
a) zur Energieeinsparung und gleichzeitigen Erhöhung der Durchlaufgeschwindigkeit die Gas-Trennsegmente (2) im Bereich der Substrat-Ebene (1) einen, über die gesamte Länge des Gas-Trennsegments (2) verlaufenden, Tunneldeckel (14) aufweisen, der mittels mehrerer Hub- und Absenkelemente (17) so an die Dicke des jeweiligen Substrats (1) angepasst werden kann, dass zwischen dem Substrat (1) und dem Tunneldeckel (14) in der Höhe nur ein geringer Freiraum-Spalt (18) verbleibt, der für einen ungestörten Durchlauf des jeweiligen Substrats (1) absolut notwendig ist; und
b) die Evakuierung von Sputter-Segmenten (3) und/oder Gas-Trennsegmenten (2) mittels einer oder mehrerer Vakuumpumpen (15) erfolgt, wobei die dabei geförderte Luft in einem volumenveränderlichen Luftspeicher (25) aufgefangen wird und beim anschließenden Wiederbelüften des betreffenden Segments (3, 2) wieder in dieses Segment (3, 2) befördert wird.

2. Vorrichtung nach Anspruch 1, **dadurch gekennzeichnet, dass** im oberen Bereich des Kessel-Deckels (4) zur Überwachung des Beschichtungsprozesses mehrere Detektions-Elemente (32) auf einer Lage-Einrichtung verschoben und hinsichtlich ihres Erfassungsbereichs lageunabhängig gedreht werden können.

3. Vorrichtung nach einem der vorhergehenden Ansprüche, **dadurch gekennzeichnet, dass** der Lagerblock (5) eine Mehrfach-Kathode in der Form zweier übereinander liegender Doppel-Targets aufweist, wobei diese mitsamt ihren Spritzblechen (9) um eine gemeinsame Drehachse (37) drehbar gelagert sind, und wobei vier verschiedene Beschichtungs-Konfigurationen ermöglicht werden.

4. Vorrichtung nach einem der vorhergehenden Ansprüche, **dadurch gekennzeichnet, dass** jeweils zwei nebeneinander liegende Kammern (41, 42) mittels eines, den gesamten Umfang umlaufenden Dichtrings (40) gegen den Außenbereich abgedichtet sind, wobei zusätzlich in diesem Bereich ein äußeres Dichtband (39) vorgesehen ist, und wobei der Raum zwischen dem Dichtring (40) und dem Dichtband (39) von einem Vakuum-Sensor (38) überwacht wird.

5. Verfahren zur Beschichtung mittels Sputtern, das aus einer Abfolge von Sputter-Segmenten (3) und Gas-Trennsegmenten (2) mit einer durchlaufenden Substrat-Ebene (1) besteht, wobei zur Durchführung des Verfahrens Sputter-Segmente (3) verwendet werden, bei denen der Kessel-Flansch (6) zur Verbindung der Kessel-Wanne (12) und dem Kessel-Deckel (4) in unmittelbarer Nähe über der Substrat-Ebene (1) angesetzt ist, damit bei Prozessänderungen und Wartungsarbeiten der gesamte Kessel-Deckel (4) mit allen darin befindlichen Bauteilen zeitsparend und kostengünstig schnell gewechselt werden kann, **dadurch gekennzeichnet, dass**
a) zur Energieeinsparung und gleichzeitigen Erhöhung der Durchlaufgeschwindigkeit die Gas-Trennsegmente (2) über die gesamte Länge mit einem Tunnel zur Abgrenzung des jeweiligen Substrats gegenüber dem angrenzenden Bereich des Gas-Trennsegments (2) versehen werden, wobei die Höhe des Tunnels der Dicke des jeweiligen Substrats in der Weise angepasst werden kann, dass der Tunneldeckel (14) mittels mehrerer Hub- und Absenkelemente (17) so in seiner Lage verändert wird, sodass zwischen dem Substrat und dem Tunneldeckel (14) ein minimaler Freiraum-Spalt verbleibt, der für einen ungestörten Durchlauf des jeweiligen Substrats (1) absolut notwendig ist; und
b) die Evakuierung von Sputter-Elementen (3) und/oder Gas-Trennsegmenten (2) mittels einer oder mehrerer Vakuumpumpen (15) erfolgt, wobei die dabei geförderte Luft in einem volumenveränderlichen Luftspeicher (25) aufgefangen wird und beim anschließenden Wiederbelüften des betreffenden Segments (3, 2) wieder in dieses Segment (3, 2) befördert wird, um die schon einmal konditionierte Luft zeitsparend und kostensparend wieder verwerten zu können.

6. Verfahren nach Anspruch 5, **dadurch gekennzeichnet, dass** zur zeitnahen Überwachung des Beschichtungsprozesses im oberen Bereich des Kessel-Deckels (4) zur Überwachung des Beschichtungsprozesses mehrere Detektions-Elemente (32) auf einer Lage-Einrichtung verschoben und hinsichtlich ihres Erfassungsbereichs lageunabhängig gedreht werden können

7. Verfahren nach Anspruch 5 oder 6, **dadurch gekennzeichnet, dass** zur Optimierung des Beschichtungsprozesses der Lagerblock (5) eine Mehrfach-Kathode in der Form zweier übereinander liegender Doppel-Targets aufweist, wobei diese mitsamt ihren Spritzblechen (9) um eine gemeinsame Drehachse (37) drehbar gelagert sind.

## Claims

1. Apparatus for coating by means of sputtering, which consists of a sequence of sputtering segments (3) and gas separating segments (2) with a continuous substrate plane (1), wherein
the sputtering segments (3) each consist of a tank tub (12) with an internal transporting device (11) for transporting substrates (1) and at least one tank cover (4) which is connected to the tank tub (4) by means of a tank flange (6), wherein the tank flange (6) is positioned in the immediate vicinity above the substrate plane (1) and wherein a cathode bearing block (5) with targets (8) and gas inlet ducts (10) is located in the immediate vicinity of the substrate with splash guards (9) in the tank cover (4),
**characterized in that**
a) to save energy and simultaneously increase the throughput speed, the gas separating segments (2) have, in the region of the substrate plane (1), a tunnel cover (14) which extends along the entire length of the gas separating segment (2) and which can be adapted to the thickness of the respective substrate (1) by means of a plurality of lifting and lowering elements (17) such that only a small clearance gap (18) remains vertically between the substrate (1) and the tunnel cover (14), said clearance gap being absolutely necessary for undisturbed passage of the respective substrate (1); and
b) sputtering segments (3) and/or gas separating segments (2) are evacuated by means of one or more vacuum pumps (15), wherein the air conveyed in the process is collected in a variable-volume air reservoir (25) and, when the relevant segment (3, 2) is subsequently aerated again, is delivered back into this segment (3, 2).

2. Apparatus according to Claim 1, **characterized in that**, in the upper region of the tank cover (4), in order to monitor the coating process, a plurality of detection elements (32) can be displaced on a locating device and can be rotated with regard to their detection range regardless of location.

3. Apparatus according to either of the preceding claims, **characterized in that** the bearing block (5) has a multiple cathode in the form of two double targets located one above the other, wherein these are mounted so as to be rotatable about a common rotation axis (37) together with their splash guards (9), and wherein four different coating configurations are allowed.

4. Apparatus according to one of the preceding claims, **characterized in that** in each case two chambers (41, 42) located next to one another are sealed off from the exterior by means of a sealing ring (40) that extends around the entire periphery, wherein an outer sealing strip (39) is additionally provided in this region, and wherein the space between the sealing ring (40) and the sealing strip (39) is monitored by a vacuum sensor (38).

5. Method for coating by means of sputtering, which consists of a sequence of sputtering segments (3) and gas separating segments (2) with a continuous substrate plane (1), wherein
in order to carry out the method, use is made of sputtering segments (3) in which the tank flange (6) for connecting the tank tub (12) and the tank cover (4) is positioned in the immediate vicinity above the substrate plane (1) in order that, in the event of process changes and maintenance work, the entire tank cover (4) with all the components located therein can be changed quickly in a time-saving and cost-effective manner,
**characterized in that**,
a) to save energy and simultaneously increase the throughput speed, the gas separating segments (2) are provided along their entire length with a tunnel for delimiting the respective substrate with respect to the adjoining region of the gas separating segment (2), wherein the height of the tunnel can be adapted to the thickness of the respective substrate in such a way that the location of the tunnel cover (14) is changed by means of a plurality of lifting and lowering elements (17) such that a minimum clearance gap remains between the substrate and the tunnel cover (14), said clearance gap being absolutely necessary for undisturbed passage of the respective substrate (1); and
b) sputtering elements (3) and/or gas separating segments (2) are evacuated by means of one or more vacuum pumps (15), wherein the air conveyed in the process is collected in a variable-volume air reservoir (25) and, when the relevant segment (3, 2) is subsequently aerated again, is delivered back into this segment (3, 2), in order that the air that has already been conditioned once can be utilized again in a time-saving and cost-effective manner.

6. Method according to Claim 5, **characterized in that**, in order to monitor the coating process in real time, in the upper region of the tank cover (4), in order to monitor the coating process, a plurality of detection elements (32) can be displaced on a locating device and can be rotated with regard to their detection range regardless of location.

7. Method according to Claim 5 or 6, **characterized in that**, in order to optimize the coating process, the bearing block (5) has a multiple cathode in the form of two double targets located one above the other, wherein these are mounted so as to be rotatable about a common rotation axis (37) together with their splash guards (9).

## Revendications

1. Dispositif de revêtement par pulvérisation cathodique, qui se compose d'une succession de segments de pulvérisation cathodique (3) et de segments de séparation de gaz (2) avec un plan de substrat défilant (1), dans lequel
les segments de pulvérisation cathodique (3) se composent respectivement d'une cuve de chaudière (12) avec un dispositif de transport intérieur (11) pour le transport de substrats (1) et au moins un couvercle de chaudière (4) qui est assemblé à la cuve de chaudière (12) au moyen d'une semelle de chaudière (6), dans lequel la semelle de chaudière (6) est placée à proximité immédiate au-dessus du plan de substrat (1) et dans lequel il se trouve dans le couvercle de chaudière (4) un bloc de palier de cathode (5) avec des cibles (8) et des canaux d'admission de gaz (10) à proximité immédiate du substrat avec des tôles anti-projections (9),
**caractérisé en ce que**
a) pour économiser l'énergie et en même temps augmenter la vitesse de défilement les segments de séparation de gaz (2) présentent dans la région du plan de substrat (1) un couvercle en tunnel (14) s'étendant sur toute la longueur du segment de séparation de gaz (2), et qui peut être adapté à l'épaisseur du substrat respectif (1), au moyen de plusieurs éléments de montée et de descente (17), de telle manière qu'il ne reste en hauteur entre le substrat (1) et le couvercle en tunnel (14) qu'une faible fente libre (18), qui est absolument nécessaire pour un défilement non perturbé du substrat respectif (1); et
b) la mise sous vide de segments de pulvérisation cathodique (3) et/ou de segments de séparation de gaz (2) est effectuée au moyen d'une ou de plusieurs pompe(s) à vide (15), dans lequel l'air ainsi transporté est capté dans un réservoir d'air à volume variable (25) et est de nouveau transporté dans ce segment (3, 2) lors de la nouvelle ventilation ultérieure du segment concerné (3, 2).

2. Dispositif selon la revendication 1, **caractérisé en ce que** plusieurs éléments de détection (32) peuvent être déplacés sur un dispositif de position et tournés en ce qui concerne leur zone de détection indépendamment de la position dans la région supérieure du couvercle de chaudière (4) pour la surveillance du processus de revêtement.

3. Dispositif selon l'une quelconque des revendications précédentes, **caractérisé en ce que** le bloc de palier (5) présente une cathode multiple sous la forme de deux doubles cibles placées l'une au-dessus de l'autre, dans lequel celles-ci sont montées avec leurs tôles anti-projections (9) de façon rotative autour d'un axe de rotation commun (37), et dans lequel quatre configurations de revêtement différentes sont possibles.

4. Dispositif selon l'une quelconque des revendications précédentes, **caractérisé en ce que** chaque fois deux chambres (41, 42) placées l'une à côté de l'autre sont rendues étanches par rapport à la région extérieure au moyen d'un anneau d'étanchéité (40) entourant toute la périphérie, dans lequel il est prévu en outre dans cette région une bande d'étanchéité extérieure (39), et dans lequel l'espace entre l'anneau d'étanchéité (40) et la bande d'étanchéité (39) est surveillé par un détecteur de vide (38).

5. Procédé de revêtement par pulvérisation cathodique, qui se compose d'une succession de segments de pulvérisation cathodique (3) et de segments de séparation de gaz (2) avec un plan de substrat défilant (1), dans lequel, pour la mise en oeuvre du procédé, on utilise des segments de pulvérisation cathodique (3), dans lesquels la semelle de chaudière (6) destinée à assembler la cuve de chaudière (12) et le couvercle de chaudière (4) est placée à proximité immédiate du plan de substrat (1), afin que, lors de changements de processus et de travaux d'entretien, tout le couvercle de chaudière (4) avec tous les composants qui s'y trouvent puissent être changés rapidement en économisant du temps et des coûts, **caractérisé en ce que**
a) pour économiser l'énergie et en même temps augmenter la vitesse de défilement les segments de séparation de gaz (2) sont munis sur toute leur longueur d'un tunnel destiné à délimiter le substrat respectif par rapport à la région adjacente du segment de séparation de gaz (2), dans lequel la hauteur du tunnel peut être adaptée à l'épaisseur du substrat respectif, de telle manière que le couvercle en tunnel (14) soit changé de position, au moyen de plusieurs éléments de montée et de descente (17), de telle manière qu'il reste entre le substrat et le couvercle en tunnel (14) une fente libre minimale, qui est absolument nécessaire pour un défilement non perturbé du substrat respectif (1); et
b) la mise sous vide de segments de pulvérisation cathodique (3) et/ou de segments de séparation de gaz (2) est effectuée au moyen d'une ou de plusieurs pompe(s) à vide (15), dans lequel l'air ainsi transporté est capté dans un réservoir d'air à volume variable (25) et est de nouveau transporté dans ce segment (3, 2) lors de la nouvelle ventilation ultérieure du segment concerné (3, 2), afin d'utiliser de nouveau l'air déjà conditionné une fois en économisant du temps et des coûts.

6. Procédé selon la revendication 5, **caractérisé en ce que** pour la surveillance immédiate du processus de revêtement plusieurs éléments de détection (32) peuvent être déplacés sur un dispositif de position et être tournés en ce qui concerne leur zone de détection indépendamment de leur position dans la région supérieure du couvercle de chaudière (4) en vue de la surveillance du processus de revêtement.

7. Procédé selon une revendication 5 ou 6, **caractérisé en ce que**, pour l'optimisation du processus de revêtement, le bloc de palier (5) présente une cathode multiple sous la forme de deux doubles cibles placées l'une au-dessus de l'autre, dans lequel celles-ci avec leurs tôles anti-projections (9) sont montées de façon rotative autour d'un axe de rotation commun (37).
